# EUROPEAN PATENT SPECIFICATION

(11) **EP 1 052 548 B1**
(45) Date of publication and mention of the grant of the patent: **08.06.2005**
(21) Application number: 00303145.7
(22) Date of filing: 14.04.2000
(51) Int. Cl.: G03F 7/20

(54) **Lithographic projection apparatus**
Lithographischer Projektionsapparat
Appareil de projection lithographique

(30) Priority: 21.04.1999 EP 99201223
(43) Date of publication of application: 15.11.2000
(73) Proprietor: ASML Netherlands B.V., 5504 DR Veldhoven (NL)
(72) Inventor: Segers, Hubert Marie, 5212 PL 's Hertogenbosch (NL); Boon, Rudolf Maria, 5653 RM Eindhoven (NL); Bijnagte, Anton Adriaan, 4196 AB Tricht (NL); Jacobs, Franciscus Mathijs, 5721 DE Asten (NL)
(74) Representative: Leeming, John Gerard

(56) References cited:
- US-A- 3 865 254

## Description

The present invention relates to a preparatory station, in particular for a lithographic projection apparatus. More particularly, the invention relates to a lithographic projection apparatus, comprising:
a radiation system for supplying a projection beam of radiation;
a mask table provided with a mask holder for holding a mask;
a substrate table provided with a substrate holder for holding a substrate;
a projection system for imaging an irradiated portion of the mask onto a target portion of the substrate; and
a preparatory station comprising an intermediate table on which a substrate can be positioned before transfer to the substrate table.

An apparatus of this type can be used, for example, in the manufacture of integrated circuits (ICs). In such a case, the mask (reticle) may contain a circuit pattern corresponding to an individual layer of the IC, and this pattern can then be imaged onto a target area (die) on a substrate (silicon wafer) which has been coated with a layer of photosensitive material (resist). In general, a single wafer will contain a whole network of adjacent dies that are successively irradiated through the reticle, one at a time. In one type of lithographic projection apparatus, each die is irradiated by exposing the entire reticle pattern onto the die in one go; such an apparatus is commonly referred to as a waferstepper. In an alternative apparatus - which is commonly referred to as a step-and-scan apparatus - each die is irradiated by progressively scanning the reticle pattern under the projection beam in a given reference direction (the "scanning" direction) while synchronously scanning the wafer parallel or anti-parallel to this direction; since, in general, the projection system will have a magnification factor M (generally < 1), the speed ν at which the wafer table is scanned will be a factor M times that at which the reticle table is scanned. More information with regard to lithographic devices as here described can be gleaned from International Patent Application WO 97/33205, for example.

Up to very recently, apparatus of this type contained a single mask table and a single substrate table. However, machines are now becoming available in which there are at least two independently movable substrate tables; see, for example, the multi-stage apparatus described in International Patent Applications WO 98/28665 and WO 98/40791. The basic operating principle behind such multi-stage apparatus is that, while a first substrate table is underneath the projection system so as to allow exposure of a first substrate located on that table, a second substrate table can run to a loading position, discharge an exposed substrate, pick up a new substrate, perform some initial measurements on the new substrate, and then stand by to transfer this new substrate to the exposure position underneath the projection system as soon as exposure of the first substrate is completed, whence the cycle repeats itself; in this manner, it is possible to achieve a substantially increased machine throughput, which in turn improves the cost of ownership of the machine.

Lithographic apparatus may employ various types of projection radiation, such as ultraviolet light (UV), extreme UV, X-rays, ion beams or electron beams, for example. Depending on the type of radiation used and the particular design requirements of the apparatus, the projection system may be refractive, reflective or catadioptric, for example, and may comprise vitreous components, grazing-incidence mirrors, selective multi-layer coatings, magnetic and/or electrostatic field lenses, *etc*; for simplicity, such components may be loosely referred to in this text, either singly or collectively, as a "lens". The apparatus may comprise components that are operated in vacuum, and are correspondingly vacuum-compatible. As mentioned in the previous paragraph, the apparatus may have more than one substrate table and/or mask table.

In a manufacturing process using a lithographic projection apparatus, a pattern in a mask is imaged onto a substrate which is at least partially covered by a layer of energy sensitive material (resist). For this process it is necessary to provide the substrate to the substrate table and to hold the substrate firmly in a fixed position on said table during the process. The substrate can be held in this fixed position with a substrate holder comprising means for applying a vacuum to a major surface of the substrate table. The vacuum will suck the substrate firmly to the substrate table. Before the substrate is provided to the substrate table it will often be processed (e.g. spin-coated with resist) in a process track and therefore the temperature of the substrate can be different to the temperature of the substrate table. This temperature difference can give a problem, because the temperature of the substrate can change after the substrate is provided to the substrate table. The the substrate holder, which does not allow the substrate to shrink. The substrate can only shrink when the tension inside the substrate is higher than the friction between the substrate and the surface of the substrate table. If this occurs, a part of the substrate will slip over the surface of the substrate table to release the tension inside the substrate. This slip movement can give an error in the super-positioning of two concurrent images exposed on successive layers on the substrate, leading to so-called overlay errors. In general, the super-positioning of two concurrent images is very accurately achieved by aligning a mark on the substrate to a reference mark (e.g. on the mask, or on a fiducial on the substrate table). If the substrate slips after aligning the substrate to said reference mark, the super-positioning of two concurrent images on the slipped part of the substrate can fail. Similar considerations apply to the case whereby the substrate is colder than the substrate table and is warmed by the substrate table. The substrate in that case would like to expand and can also slip over the surface of the substrate table.

US-A-3 865 254 discloses a pre-alignment system for substrates in which the substrate is transported on an air bearing track and supported on an air cushion whilst being rotated to a current position.
It is an object of the invention to alleviate, at least partially, the above problems. Accordingly the present invention provides a lithographic projection apparatus, comprising:
a radiation system for supplying a projection beam of radiation;
a mask table provided with a mask holder for holding a mask;
a substrate table provided with a substrate holder for holding a substrate;
a projection system for imaging an irradiated portion of the mask onto a target portion of the substrate; and
a preparatory station comprising an intermediate table on which a substrate can be positioned before transfer to the substrate table, said intermediate table comprising a major surface provided with a plurality of apertures, and gas bearing means for generating a gas bearing between said major surface and a substrate located thereon;
characterized in that said preparatory station comprises first control means for regulating the temperature of said gas.

By directly regulating the temperature of said gas, the temperature of the substrate can be influenced as well. Especially when the gap between the substrate and the intermediate table is large, it may be desirable to regulate the temperature of the gas directly instead of by regulating only the temperature of the intermediate table.

The gas bearing substantially removes the friction between the substrate and the major surface of the intermediate table. The substrate can easily expand and shrink on the gas bearing when the temperature of the substrate changes. Another advantage of using a gas bearing between the surface of the intermediate table and the substrate is that contamination of the backside of the substrate by foreign particles present on the major surface of the intermediate table is avoided. Particles already collected on the backside can even be blown away from the backside by the gas bearing.

The gas used in the gas bearing can be air and the gas source can be provided with means for filtering the gas (e.g. air from outside) such that it is substantially free of foreign particles. Alternatively, other gases can be used, for example, nitrogen or helium. As will be appreciated by the skilled artisan, one can control the gas bearing by having apertures for the inflow of gas to the gas bearing and also apertures for the evacuation of gas from the gas bearing. A particular pressure for the inflow of gas may be between about 1.1 and 1.5 bar whereas a reduced gas pressure for the evacuation of the gas may be between about 0.5 and the 0.9 bar, for example. The gas bearing may have a thickness less than about 150 µm, for example.

The preparatory station can comprise gas ionizing means to ionize the gas used to create the gas bearing. By using the gas ionizing means the substrate can be gradually discharged from any initially charged state (since a statically charged part of the substrate will attract ions with an opposite charge, so that the charged part will be neutralized by the ions). This gradual discharging is advantageous, because it prevents a sudden discharge of the substrate, e.g. if it comes into the neighborhood of a conductor. A sudden discharge, for example with a spark, can cause damage to the substrate or to the sensitive structures already created thereon. As will be appreciated by the skilled artisan, the gas ionizing means can, for example, employ radioactive ionization or corona discharge to ionize the gas; corona discharge is a method applying a high voltage to a sharp point to ionize the gas in the vicinity of said point.

The intermediate table can comprise second control means for controlling the temperature of that table. By controlling the temperature of the intermediate table, the temperature of the substrate can be influenced. A first possible mechanism for effecting such influence can be thermal radiation from the substrate to the intermediate table. A second mechanism can be that the temperature of the intermediate table influences the temperature of the gas used in the gas bearing, and the temperature of the gas influences the temperature of the substrate. Especially when the gap caused by the gas bearing between the substrate and the surface of the intermediate table is very thin, the temperature of said table can have a strong and rapid influence on the temperature of the substrate.

An advantage of the invention as described above is that said first and second control means can maintain the intermediate table and the gas at a temperature substantially equal to the temperature of the substrate table (e.g. as measured using temperature sensing means in the substrate table). In that case the temperature of the gas and the intermediate table will change the temperature of the substrate to a temperature substantially equal to the temperature of the substrate table. After the substrate is provided to the substrate table the temperature of the substrate will not change significantly anymore, and therefore no substantial expansion or shrinkage of the substrate will occur on the substrate table. Accordingly, the chance that a slip of the substrate on the substrate table will occur can be minimized when these measures are taken.

In another embodiment according to the invention, the said preparatory station further comprises:
detecting means for detecting a first position of said substrate on said intermediate table;
calculating means for calculating a required displacement between said first position and a desired position of the substrate on the intermediate table; and
moving means for moving said substrate from said first position to said desired position.

The detecting means can comprise edge detecting means for detecting the position of the edge of said substrate on said intermediate table. The detecting means can comprise capacitive sensors or optical sensors, e.g. a camera system or a CCD array. The information obtained with the detecting means about the first position of the substrate on the intermediate table, together with information regarding the desired position of the object on the table, can be processed in calculating means so as to calculate the required displacement. Said desired position of the substrate on the intermediate table can be determined beforehand and stored in a memory device, wherefrom it can be retrieved when necessary. The moving means can comprise, for example, a robot arm.

The substrate can be brought into the desired position and to a certain temperature simultaneously. This improves the time efficiency of the apparatus (throughput-enhancement). Another advantage is that the accuracy with which the detecting means can detect the first position of the substrate on the intermediate table is better, because the substrate is perfectly flat on the gas bearing. This is because the gas bearing exerts a force on the substrate that is equally divided over the total backside of the substrate, so that the substrate it is not stressed (and thus bent or warped) by the substrate holder.

The invention also relates to a manufacturing method for a lithographic projection apparatus comprising the steps of:
(a) providing a mask table with a mask which contains a pattern,
(b) providing a substrate table with a substrate which is at least partially covered by a layer of radiation-sensitive material, and
(c) using a projection beam of radiation to project an irradiated part of the mask onto a target area of the layer of radiation-sensitive material; wherein prior to step (b) the following steps are carried out:
   providing the substrate to an intermediate table comprising a major surface provided with a plurality of apertures, and maintaining the substrate for a given time interval upon a gas bearing generated between the said major surface and the substrate whilst regulating the temperature of the gas forming the gas bearing.

Detaining the substrate on the gas bearing in this manner allows the substrate to shrink or expand when its temperature changes without tension arising between the substrate and the intermediate table.

In a manufacturing process using a lithographic projection apparatus according to the invention, a pattern in a mask is imaged onto a substrate which is at least partially covered by a layer of energy-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, *e.g.* an IC. Such a patterned layer may then undergo various processes such as etching ion-implantation (doping), metallization, oxidation, chemo-mechanical polishing, *etc.*, all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, *etc.* Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

The invention as explained hereabove may also be applied to a preparatory station for preparing a mask.

Although specific reference has been made to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, *etc.* The skilled artisan will appreciate that, in the context of such alternative applications, any use of the terms "reticle", "wafer" or "die" in this text should be considered as being replaced by the more general terms "mask", "substrate" and "target area", respectively.

The invention and its advantages will be further elucidated with the aid of exemplary embodiments and the accompanying schematic drawings, whereby:
Figure 1 schematically depicts a lithographic projection apparatus suitable for use with the invention;
Figure 2a shows a cross sectional view of a part of a preparatory station according to the invention (in elevation);
Figure 2b shows a cross sectional view of a gas source as can be applied in a preparatory station according to the invention;
Figure 2c is a plan view of the subject of Fig. 2a;
Figure 3 shows a third embodiment of a preparatory station according to the invention;
Figure 4 shows a fourth embodiment of a preparatory station according to the invention.

### Embodiment 1

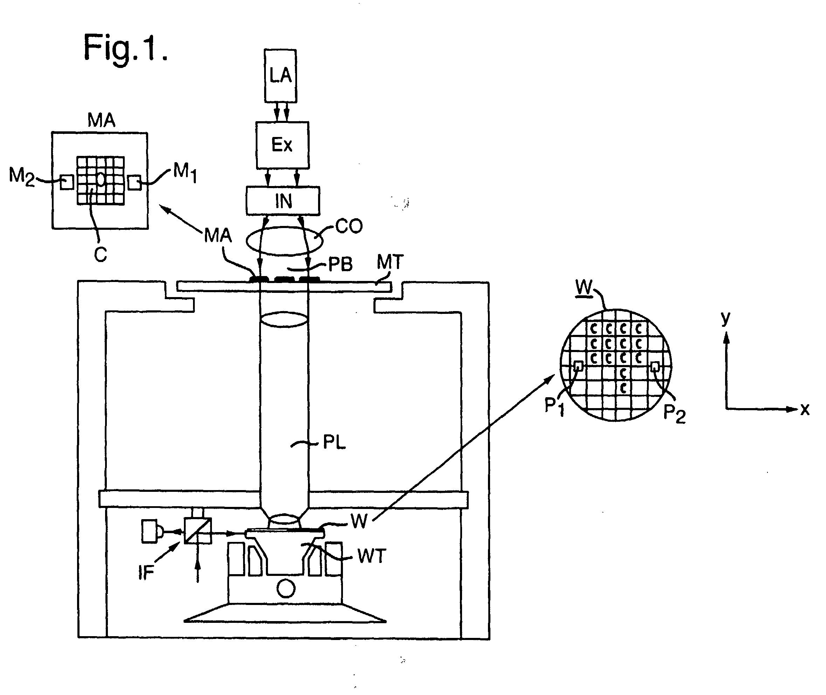

Figure 1 schematically depicts a lithographic projection apparatus. The apparatus comprises:
- a radiation system LA, Ex, IN, CO for supplying a projection beam PB of radiation, such as ultraviolet light (e.g. at a wavelength of 365 nm, 248 nm, 193 nm or 157 nm), EUV, X-rays, electrons or ions;
- a mask table MT provided with a mask holder for holding a mask MA (*e.g.* a reticle);
- a substrate table WT provided with a substrate holder for holding a substrate W (*e.g.* a resist-coated silicon wafer);
- a projection system PL (*e.g.* a lens or catadioptric system, a mirror group or an array of field deflectors) for imaging an irradiated portion of the mask MA onto a target portion C (die) of the substrate W.

As here depicted, the apparatus comprises refractive components. However, it may alternatively comprise one or more reflective components.

The radiation system comprises a source LA (*e.g.* a Hg lamp or excimer laser, a thermionic gun or ion source, or a wiggler/undulator situated around the path of an electron beam in a storage ring or synchrotron) which produces a beam of radiation. This beam is passed along various optical components, - *e.g.* beam shaping optics Ex, an integrator IN and a condensor CO - so that the resultant beam PB has a desired shape and intensity distribution in its cross-section.

The beam PB subsequently intercepts the mask MA which is held in the mask holder on the mask table MT. Having passed through the mask MA, the beam PB passes through the projection system PL, which focuses the beam PB onto a target area C of the substrate W. With the aid of the interferometric displacement and measuring means IF, the substrate table WT can be moved accurately, *e.g.* so as to position different target areas C in the path of the beam PB. Similarly, the mask table MT can be positioned very accurately with respect to the beam PB. In general, movement of the mask table MT and the substrate table WT will be realized with the aid of a long stroke module (course positioning) and a short stroke module (fine positioning), which are not explicitly depicted in Figure 1. In the case of a waferstepper, as opposed to a step-and-scan device, the mask table MT may only be moved with a short stroke module, or may be just fixed.
The depicted apparatus can be used in two different modes:
- In step mode, the mask table MT is kept essentially stationary, and an entire mask image is projected in one go (*i.e.* a single "flash") onto a target area C. The substrate table WT is then shifted in the X and/or Y directions so that a different target area C can be irradiated by the (stationary) beam PB;
- In scan mode, essentially the same scenario applies, except that a given target area C is not exposed in a single "flash". Instead, the mask table MT is movable in a given direction (the so-called "scan direction", *e.g.* the X direction) with a speed *v*, so that the projection beam PB is caused to scan over a mask image; concurrently, the substrate table WT is simultaneously moved in the same or opposite direction at a speed *V* = *Mv,* in which *M* is the magnification of the projection system PL (typically, *M* = 1/4 or 1/5). In this manner, a relatively large target area C can be exposed, without having to compromise on resolution.

### Embodiment 2

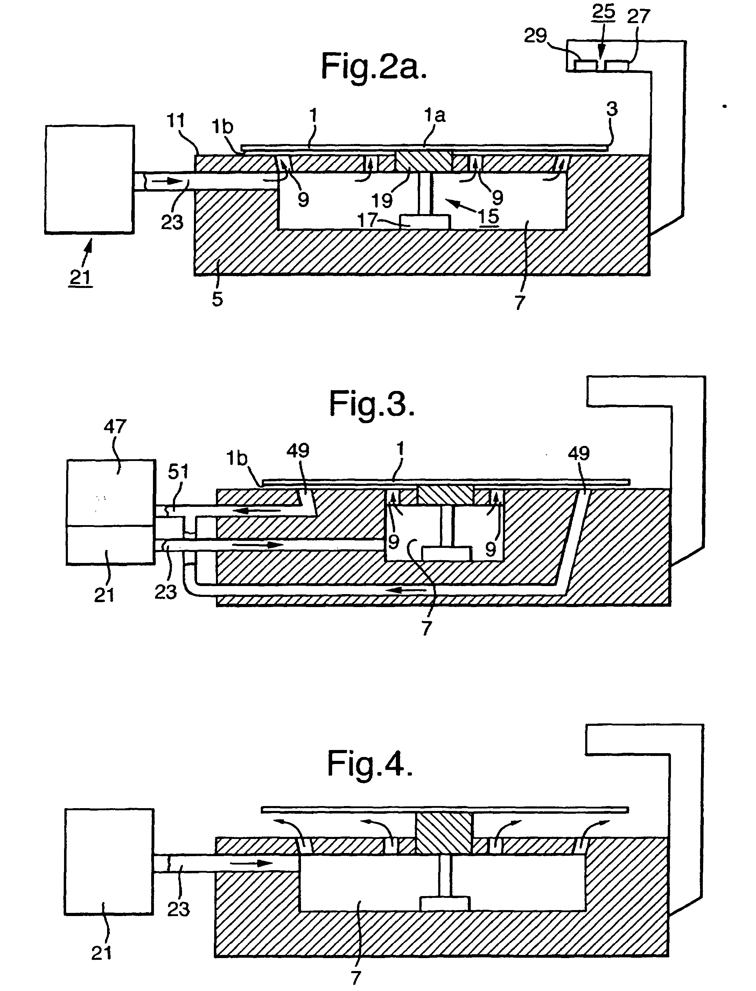

Figure 2a shows a cross-sectional view of a preferred embodiment of a preparatory station according to the invention. From the figure the following items can be seen;
- a substrate (wafer) 1 having an edge 3, a front side 1a and a backside 1b;
- an intermediate table 5 comprising a gas chamber 7 connected via apertures 9 to a major surface 11;
- a rotation unit 15 comprising an actuator 17 and vacuum holding means 19 for holding and rotating the substrate 1 above the intermediate table 5;
- gas bearing means comprising a gas source 21 for supplying a gas to the major surface 11 via the apertures 9, the gas chamber 7 and a tube 23;
- detecting means 25 comprising edge detecting means 27 for detecting the edge 3 of the substrate 1 and mark detecting means 29 for detecting a mark on the front side 1a of the substrate 1.

The substrate 1 will be moved to the intermediate table 5 by substrate transporting means, e.g. a robot arm. In general, the substrate is held on the backside 1b or the edge 3 by the substrate transporting means, because on the front side 1a sensitive structures already created on the substrate 1 can be present The substrate transporting means will hold the substrate 1 above the major surface 11, and the vacuum holding means 19 will be moved by the actuator 17 toward that surface 11 up to the backside 1b in a direction perpendicular thereto. A vacuum is applied to the vacuum holding means 19, such that the backside 1b of the substrate 1 is sucked to the vacuum holding means 19. The substrate transporting means are then released from the backside 1b of the substrate 1 and are moved away from the major surface 11. The actuator 17 retracts the holding means 19 towards the major surface 11 in a direction substantially perpendicular to that surface 11, and gas is supplied to that surface 11 by the gas source 21 via the tube 23, the gas chamber 7 and the apertures 9. The gas creates a gas bearing between the substrate 1 and the major surface 11.

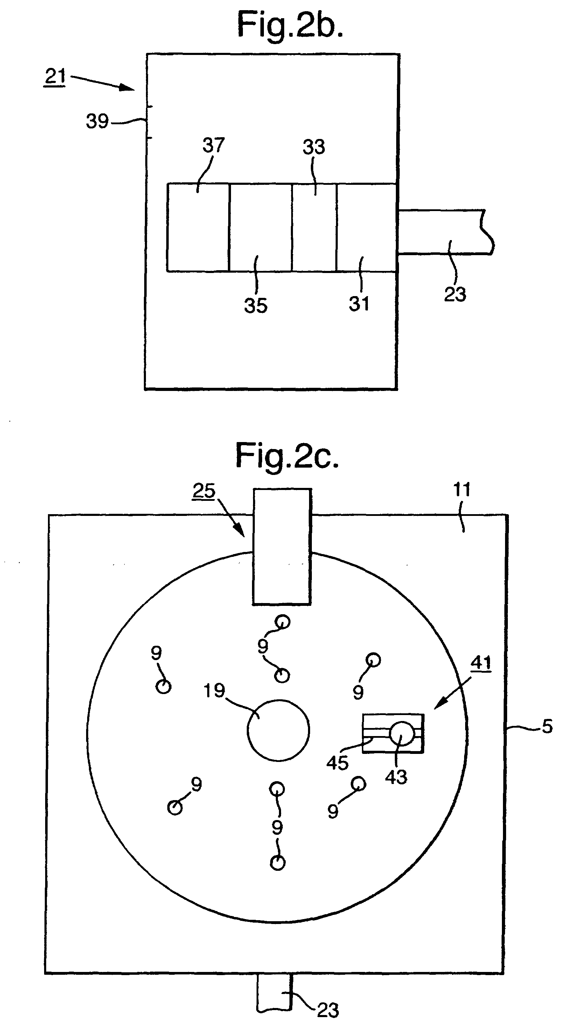

As shown in figure 2b the gas source 21 can comprise a pump 31, gas ionizing means 33, first control means 35 for temperature control of the gas, gas filtering means 37 and an air inlet 39. If the gas bearing is created with air, said air will enter the gas source 21 through the air inlet 39 and will be filtered by gas filtering means 37 so as to make the air substantially free of foreign particles. Thereafter the air will be brought to a required temperature by second control means 35, ionized by ionizing means 33, brought to a required pressure by pump 31 and delivered through the tube 23 to the intermediate table 5. If a gas other than air is used the filtering means 37 and the inlet 39 may be absent. Gases such as nitrogen and helium can be used for this purpose. The gas ionizing means 33 ionize the gas used to create the gas bearing. The ions in the gas will be attracted by any static charge collected on the backside 1b of the substrate 1, and will neutralize such charge.

The intermediate table 5 (figure 2a) can comprise second control means for controlling the temperature of that table. By controlling the temperature of the intermediate table 5, the temperature of the substrate 1 can be influenced. A first possible mechanism for effecting this influence can be thermal radiation between the substrate 1 and the surface 11. A second mechanism can be that the temperature of the intermediate table 5 influences the temperature of the gas used in the gas bearing, and the temperature of the gas influences the temperature of the substrate 1. Especially when the gap caused by the gas bearing between the substrate 1 and the surface 11 is thin, for example, less than 150 µm, the temperature of said table 5 can have a strong and rapid influence on the temperature of the substrate 1.

It will be advantageous if said first and/or said second control means maintain the intermediate table 5 and the gas at a temperature substantially equal to the temperature of the substrate table WT. One could, for example, employ a sensor for measuring the temperature of the substrate table WT and one could regulate the temperature in the first and/or second control means such that it is substantially equal to said measured temperature. This gives an advantage because the temperature of the substrate 1 before transfer to the substrate table WT will be made equal to the temperature of the substrate table WT, and therefore substantially no shrinkage or expansion will occur after placement of the substrate 1 upon the substrate table WT.

In measuring the orientation of the substrate 1 on the intermediate table 5 the mark detecting means 29 can be used to detect a mark on the front side of the substrate 1a, and/or the edge detecting means 27 can be used to detect the edge 3 of the substrate 1. The edge detecting means 27 measure the eccentricity of the substrate 1 on the intermediate table 5. This is accomplished by the actuator 17 which rotates the vacuum holding means 19 around an axis perpendicular to the plane of the intermediate table such that the edge 3 of the substrate 1 rotates underneath the edge detecting means 27 (see Fig. 2c, which shows a plan view of the intermediate plane 5 without a substrate positioned thereon). The edge detecting means 27 can employ a capacitive sensor or an optical sensor (e.g. a camera system or a CCD array) to measure the position of the edge 3 of the substrate 1. In this way:
- The notch or flat edge can be automatically oriented as desired, before the substrate 1 is transferred to the substrate table WT.
- It can be determined if the said eccentricity of the substrate 1 upon the table 5 exceeds a threshold value which, when translated to the substrate table WT, would cause the substrate 1 to fall outside the capture range of the alignment module employed at the substrate table WT.
If the first position of the substrate 1 on the intermediate table 5 is not within the capture range of the alignment module employed at the substrate table WT, one would like to reposition the substrate 1 upon the intermediate table 5, because otherwise the substrate 1 can not be accurately transferred to the required position on the substrate table WT for exposure. For this repositioning the intermediate table 5 is provided with moving means 41 comprising second vacuum holding means 43 which can be sucked against the backside 1b of the substrate 1, and displacement means 45 for moving said second holding means 43. If the substrate 1 is not in the desired in-plane position on the intermediate table 5 the substrate 1 on the intermediate table will be rotated such that the center of the substrate 1 and the center of the holding means 19 will be in one straight line with moving means 41.
Subsequently, the second holding means 43 will be sucked to the backside 1b of the substrate 1 and the vacuum in the holding means 19 will be released. The second holding means 43 will be moved by the displacement means 45, to or away from the center of the holding means 19, such that after release of the vacuum in the second holding means 43, the substrate 1 will have the required in-plane position. In said required position the center of the substrate 1 will be substantially at the same position as the center of the holding means 19. If necessary more than one moving means 41 can be used.

### Embodiment 3

Figure 3 shows a third embodiment of the invention in cross section. The gas source 21 delivers gas through the tube 23, the gas chamber 7 and the apertures 9 to the gas bearing. The gas in the gas bearing will be evacuated through the evacuation apertures 49 and the evacuation tube 51 to an evacuation pump 47. Any foreign particles present on the backside 1b of the substrate 1 can be evacuated to the evacuation pump 47 in this embodiment. If the evacuation pump were not present, foreign particles could be blown off the backside of the substrate 1 into the apparatus, where the foreign particles could cause contamination problems. Another advantage of evacuating the gas is that it is easier to control the thickness of the gas bearing if the inflow and the evacuation of gas are controlled, as the skilled artisan will appreciate. The evacuated gas can be returned to the gas source 21, such that after filtering it can be reused in the gas bearing.

### Embodiment 4

Figure 4 shows a fourth embodiment of the invention in cross section. In this embodiment the gas bearing is relatively thick (i.e. larger than 150 µm). Gas will be supplied to the gas bearing from the gas source 21 through the tube 23, the gas chamber 7 and the apertures 9. If such a gas bearing is used the gas source 21 will advantageously be equipped with first control means for directly controlling the temperature of said gas.

## Claims

1. A lithographic projection apparatus, comprising:
a radiation system (Ex, IN,LO) for supplying a projection beam of radiation;
a mask table (MT) provided with a mask holder for holding a mask;
a substrate table (WT) provided with a substrate holder for holding a substrate;
a projection system (PL) for imaging an irradiated portion of the mask onto a target portion of the substrate; and
a preparatory station comprising an intermediate table (5) on which a substrate can be positioned before transfer to the substrate table (WT), said intermediate table comprising a major surface (11) provided with a plurality of apertures (a), and gas bearing means (21) for generating a gas bearing between said major surface and a substrate located thereon;
**characterized in that** said preparatory station comprises first control means (35) for regulating the temperature of said gas.

2. An apparatus according to claim 1, **characterized in that** said preparatory station comprises gas ionizing means (33) for ionizing said gas.

3. An apparatus according to claim 1 or 2, **characterized in that** said intermediate table comprises second control means for regulating the temperature of that table.

4. An apparatus according to claim 1, 2 or 3, **characterized in that** said gas bearing has a thickness less than 150 µm.

5. An apparatus according to claim 1, 2 or 4, **characterized in that** said control means maintain the intermediate table and/or the gas at a temperature substantially equal to the temperature of the substrate table.

6. An apparatus according to any one of claims 1-5, **characterized in that** said apparatus further comprises:
detecting means (25, 29) for detecting a first position of said substrate on said intermediate table;
calculating means for calculating a required displacement between said first position and a desired position of the substrate on the intermediate table; and
moving means (41) for moving said substrate from said first position to said desired position.

7. An apparatus according to claim 6, **characterized in that** said detecting means (27) are constructed and arranged to detect an edge of the substrate.

8. An apparatus according to claim 6 or 7, **characterized in that** said detecting means (29) are constructed and arranged to detect a mark on the substrate.

9. A manufacturing method for a lithographic projection apparatus comprising the steps of:
(a) providing a mask table with a mask which contains a pattern,
(b) providing a substrate table with a substrate which is at least partially covered by a layer of radiation-sensitive material, and
(c) using a projection beam of radiation to project an irradiated part of the mask onto a target area of the layer of radiation-sensitive material; wherein prior to step (b) the following steps are carried out:
providing the substrate to an intermediate table comprising a major surface provided with a plurality of apertures, and maintaining the substrate for a given time interval upon a gas bearing generated between the said major surface and the substrate, whilst regulating the temperature of the gas forming the gas bearing.

10. A substrate preparing device comprising an intermediate table on which a substrate can be positioned before transfer to a substrate table in a lithographic projection apparatus; said intermediate table comprising a major surface provided with a plurality of apertures, and gas bearing means for generating a gas bearing between said major surface and a substrate located thereon; **characterized by** control means for regulating the temperature of the gas of said gas bearing.

## Patentansprüche

1. Lithographischer Projektionsapparat, mit:
einem Strahlungssystem (Ex, IN, LO), über das ein Projektionsstrahl mit Strahlung zugeführt wird;
einem Maskentisch (MT), der mit einem Maskenhalter zum Halten einer Maske versehen ist;
einem Substrattisch (WT), der mit einem Substrathalter zum Halten eines Substrats versehen ist;
einem Projektionssystem (PL) über das ein bestrahlter Bereich der Maske auf einen Zielbereich des Substrats abgebildet wird; und mit
einer Vorbereitungsstation, die einen Zwischentisch (5) umfasst, auf den ein Substrat positioniert werden kann, bevor es zum Substrattisch (WT) geleitet wird, wobei der besagte Zwischentisch eine Hauptfläche (11) mit einer Vielzahl von Öffnungen (a) sowie gasgelagerte Mittel (21) zum Erzeugen eines Gaslagers zwischen der besagten Hauptfläche und einem darauf angeordneten Substrat aufweist;
**dadurch gekennzeichnet, dass** die besagte Vorbereitungsstation erste Einrichtungen (35) zur Regelung der Temperatur des besagten Gases umfasst.

2. Apparat nach Anspruch 1, **dadurch gekennzeichnet, dass** die besagte Vorbereitungsstation Gasionisierungsmittel (33) zum Ionisieren des besagten Gases umfasst.

3. Apparat nach Anspruch 1 oder 2, **dadurch gekennzeichnet, dass** der besagte Zwischentisch zweite Einrichtungen zur Regelung der Temperatur des besagten Tisches umfasst.

4. Vorrichtung nach Anspruch 1, 2 oder 3, **dadurch gekennzeichnet, dass** die Dicke des besagten Gaslagers weniger als 150 µm beträgt.

5. Apparat nach Anspruch 1, 2 oder 4, **dadurch gekennzeichnet, dass** die besagten Regeleinrichtungen den Zwischentisch und/oder das Gas auf einer Temperatur halten, die der Temperatur des Substrattisches im wesentlichen gleich ist.

6. Apparat nach einem der Ansprüche 1-5, **dadurch gekennzeichnet, dass** der besagte Apparat ferner umfasst:
Erfassungsmittel (25, 29) zum Erfassen einer ersten Position des besagten Substrats auf dem besagten Zwischentisch;
Berechnungsmittel zum Berechnen einer erforderlichen Verschiebung zwischen der besagten ersten Position und einer gewünschten Position des Substrats auf dem Zwischentisch; und
Bewegungsmittel (41) zum Bewegen des besagten Substrats von der besagten ersten Position in die gewünschte Position.

7. Apparat nach Anspruch 6, **dadurch gekennzeichnet, dass** die besagten Erfassungsmittel (27) konstruiert und angeordnet sind, um eine Kante des Substrats zu erfassen.

8. Apparat nach Anspruch 6 oder 7, **dadurch gekennzeichnet, dass** die besagten Erfassungsmittel (29) konstruiert und angeordnet sind, um eine Marke auf dem Substrat zu erfassen.

9. Verfahren zur Herstellung eines lithographischen Projektionsapparats, das folgende Schritte umfasst:
(a) Aufbringen einer ein Muster aufweisenden Maske auf einen Maskentisch,
(b) Aufbringen eines wenigstens teilweise von einer Schicht aus strahlungsempfindlichem Material bedeckten Substrats auf einen Substrattisch und
(c) Verwenden eines Projektionsstrahls mit Strahlung, um einen bestrahlten Teil der Maske auf einen Zielbereich der Schicht aus strahlungsempfindlichem Material zu projizieren; wobei vor Schritt (b) folgende Schritte durchgeführt werden:
Aufbringen des Substrats auf einen Zwischentisch, der eine Hauptfläche mit einer Vielzahl von Öffnungen umfasst, und Halten des Substrats über eine bestimmte Zeitdauer auf einem Gaslager, das zwischen der besagten Hauptfläche und dem Substrat erzeugt ist, während die Temperatur des das Gaslager bildenden Gases geregelt wird.

10. Vorrichtung zum Vorbereiten eines Substrats, mit einem Zwischentisch, auf den ein Substrat positioniert werden kann, bevor es zu einem Substrattisch in einem lithographischen Projektionsapparat geführt wird; wobei der besagte Zwischentisch eine Hauptfläche mit einer Vielzahl von Öffnungen und Gaslagermittel zum Erzeugen eines Gaslagers zwischen der besagten Hauptfläche und einem darauf abgelegten Substrat aufweist, **gekennzeichnet durch** Einrichtungen zur Regelung der Gastemperatur des besagten Gaslagers.

## Revendications

1. Appareil de projection lithographique, comportant :
un système de rayonnement (Ex, IN, LO) pour fournir un faisceau de projection de rayonnement ;
une table de masque (MT) munie d'un support de masque pour supporter un masque ;
une table de substrat (WT) munie d'un support de substrat pour supporter un substrat ;
un système de projection (PL) pour produire une image d'une partie irradiée du masque sur une partie cible du substrat ; et
un poste préparatoire comportant une table intermédiaire (5) sur laquelle un substrat peut être positionné avant transfert sur la table de substrat (WT), ladite table intermédiaire comportant une surface principale (11) munie d'une pluralité d'ouvertures (a), et des moyens de palier à gaz (21) pour générer un palier à gaz entre ladite surface principale et un substrat situé sur celle-ci ;
**caractérisé en ce que** ledit poste préparatoire comporte des premiers moyens de commande (35) pour réguler la température dudit gaz.

2. Appareil selon la revendication 1, **caractérisé en ce que** ledit poste préparatoire comporte des moyens d'ionisation de gaz (33) pour ioniser ledit gaz.

3. Appareil selon la revendication 1 ou 2, **caractérisé en ce que** ladite table intermédiaire comporte des seconds moyens de commande pour réguler la température de cette table.

4. Appareil selon la revendication 1, 2 ou 3, **caractérisé en ce que** ledit palier à gaz a une épaisseur inférieure à 150 µm.

5. Appareil selon la revendication 1, 2 ou 4, **caractérisé en ce que** lesdits moyens de commande maintiennent la table intermédiaire et/ou le gaz à une température sensiblement égale à la température de la table de substrat.

6. Appareil selon l'une quelconque des revendications 1 à 5, **caractérisé en ce que** ledit appareil comporte de plus :
des moyens de détection (25, 29) pour détecter une première position dudit substrat sur ladite table intermédiaire ;
des moyens de calcul pour calculer un déplacement nécessaire entre ladite première position et une position voulue du substrat sur la table intermédiaire ; et
des moyens de déplacement (41) pour déplacer ledit substrat de ladite première position à ladite position voulue.

7. Appareil selon la revendication 6, **caractérisé en ce que** lesdits moyens de détection (27) sont réalisés et agencés pour détecter un bord du substrat.

8. Appareil selon la revendication 6 ou 7, **caractérisé en ce que** lesdits moyens de détection (29) sont réalisés et agencés pour détecter une marque sur le substrat.

9. Procédé de fabrication pour un appareil de projection lithographique comportant les étapes consistant à :
(a) fournir une table de masque ayant un masque qui présente un motif,
(b) fournir une table de substrat ayant un substrat qui est au moins partiellement recouvert d'une couche de matériau sensible au rayonnement, et
(c) utiliser un faisceau de projection de rayonnement pour projeter une partie irradiée du masque sur une zone cible de la couche de matériau sensible au rayonnement ; dans lequel avant l'étape (b) les étapes suivantes sont effectuées :
fournir le substrat à une table intermédiaire comportant une surface principale munie d'une pluralité d'ouvertures, et maintenir le substrat pendant un intervalle de temps donné sur un palier à gaz généré entre ladite surface principale et le substrat, tout en régulant la température du gaz formant le palier à gaz.

10. Dispositif de préparation de substrat comportant une table intermédiaire sur laquelle un substrat peut être positionné avant transfert sur une table de substrat dans un appareil de projection lithographique ; ladite table intermédiaire comportant une surface principale munie d'une pluralité d'ouvertures, et des moyens de palier à gaz pour générer un palier à gaz entre ladite surface principale et un substrat situé sur celle-ci ; **caractérisé par** des moyens de commande pour réguler la température du gaz dudit palier à gaz.
